# EUROPEAN PATENT APPLICATION

(11) **EP 2 063 693 A2**
(43) Date of publication of application: **27.05.2009**
(21) Application number: 08169344.2
(22) Date of filing: 18.11.2008
(51) Int. Cl.: H05K 5/02

(54) **Plasma display device**

(30) Priority: 26.11.2007 KR 20070120982
(71) Applicant: Samsung SDI Co., Ltd., Suwon-si, Gyeonggi-do (KR)
(72) Inventor: Jeong, Kwang-Jin, Suwon-si, Gyeonggi-do (KR)
(74) Representative: Walaski, Jan Filip

(57) **Abstract**

A plasma display device includes a plasma display panel and a chassis base for supporting the plasma display panel, the chassis base having an edge. A printed circuit board assembly is on the chassis base, a flexible printed circuit electrically connects electrodes of the plasma display panel to the printed circuit board assembly and a driver integrated circuit is on the flexible printed circuit. A cover plate covers the flexible printed circuit and the driver integrated circuit and is mounted on the chassis base and a connector combines the edge of the chassis base to the cover plate to prevent relative movement between the chassis base and the cover plate.

## Description

The present invention relates to a plasma display device, and more particularly, to a protection device for protecting a driver integrated circuit (IC) of the plasma display device.

As is known, a plasma display device displays images on a plasma display panel (PDP). Electrodes (e.g., display electrodes and address electrodes) of the PDP are electrically connected to a printed circuit board assembly (PCA) via a flexible printed circuit (FPC). A driver integrated circuit (IC) is mounted on the FPC and selectively applies a voltage signal to the electrodes (e.g., the address electrodes) of the PDP according to a control signal transferred from the PCA.

To connect the FPC and the driver IC, a chip on board (COB) is formed such that the driver IC is mounted on a printed circuit board (PCB), or a chip on film (COF) and a tape carrier package (TCP) are formed such that the driver IC is mounted on a film constituting the FPC. The TCP is less expensive than the COF, uses a small driver IC, and does not have a heat dissipation mechanism. Thus, the TCP has low heat dissipation characteristics compared with the COF. Therefore, in order to protect the driver IC and improve the heat dissipation characteristics, a cover plate is used for the TCP.

As an example, the driver IC is positioned between the cover plate and a chassis base. Thermal grease and a heat dissipation pad are provided on either surface of the driver IC. Accordingly, heat generated from the driver IC is transferred to the chassis base or to the cover plate via the thermal grease or the heat dissipation pad and then emitted. The cover plate may have a length generally corresponding to one side of the chassis base, and may be mounted on a plurality of mounting points provided at the chassis base by set screws such that the cover plate covers the FPC and the driver IC.

In a conventional plasma display device, in mounting the cover plate on the chassis base, the cover plate may be divided into a region fastened by set screws and may have end portions that are not fastened. Compared with the region fastened by set screws, the unfastened end portions of the cover plate are not firmly supported or secured at the chassis base and may have high mobility. Accordingly, both end portions of the cover plate may flex toward the chassis base causing the driver IC to bear a shear stress between the chassis base and the cover plate. The shear stress may cause cracks on the driver IC, and may severely damage the driver IC. For example, damage of the driver IC connected with the address electrodes causes defective vertical lines in the PDP.

Aspects of the present invention provide a plasma display device for preventing a driver IC between a chassis base and a cover plate from being cracked or damaged, a reinforced support structure of a cover plate on a chassis base, and reduced noise generated around the cover plate.

In one embodiment, a plasma display device includes a plasma display panel and a chassis base for supporting the plasma display panel, the chassis base having an edge. A printed circuit board assembly is on the chassis base, a flexible printed circuit electrically connects electrodes of the plasma display panel to the printed circuit board assembly and a driver integrated circuit is on the flexible printed circuit. A cover plate covers the flexible printed circuit and the driver integrated circuit and is mounted on the chassis base and a connector holds the edge of the chassis base to the cover plate to prevent relative movement between the chassis base and the cover plate.

In one embodiment, the cover plate includes a first plate generally parallel to the chassis base and a second plate extending from and substantially perpendicular to the first plate. The connector may be integral with or separate from the second plate.

The connector may further include at least one receiving recess adapted to receive and support the edge of the chassis base, wherein the connector protrudes from the second plate toward the chassis base. The receiving recess may be adapted to receive a corner of the chassis base and a length of the at least one receiving recess may generally correspond to a length of the second plate.

The chassis base may include a tab at a corner of the chassis base, the tab being at least partially inserted in the at least one receiving recess. In one embodiment, the connector includes a first receiving recess adapted to receive and support an edge of the second plate and a second receiving recess adapted to receive and support the edge of the chassis base. Additionally, the first receiving recess may face an edge of the second plate and extend along an entire length of the connector and the second receiving recess may face the edge of the chassis base and extend along an entire length of the connector. Further, the first and second receiving recess may extend partially along a length of the connector such that the first and second receiving recess contact two edges of a corner of the second plate and of the chassis base, respectively.

The accompanying drawings, together with the specification, illustrate exemplary embodiments of the present invention, and, together with the description, serve to explain the principles of the present invention.
FIG. 1 is an exploded perspective view of a plasma display device according to a first embodiment of the present invention.
FIG. 2 is a cross-sectional view taken along the line II-II of FIG. 1.
FIG. 3 is a perspective view of a cover plate of the first embodiment.
FIG. 4 is a partial perspective view showing a combined chassis base and cover plate.
FIG. 5 is a cross-sectional view according to a second exemplary of the present invention.
FIG. 6 is an exploded perspective view of a cover plate and a connector according to the second exemplary embodiment of the present invention.
FIG. 7 is a partial perspective view showing a combined structure of a chassis base, the cover plate, and the connector.
FIG. 8 is a partial perspective view showing a combined structure of the chassis base, the cover plate, and the connector according to a third exemplary embodiment of the present invention.

In the following detailed description, only certain exemplary embodiments of the present invention are shown and described, by way of illustration. As those skilled in the art would recognize, the invention may be embodied in many different forms and should not be construed as being limited to the embodiments set forth herein. Like reference numerals designate like elements throughout the specification.

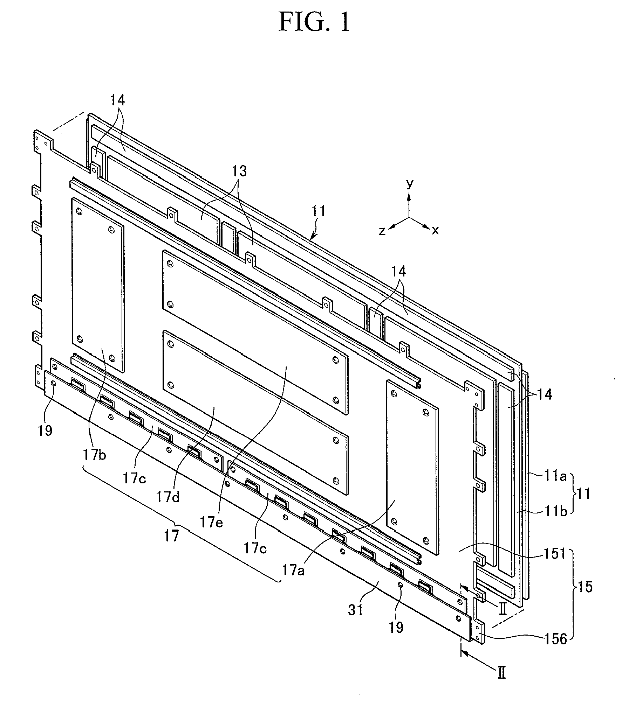

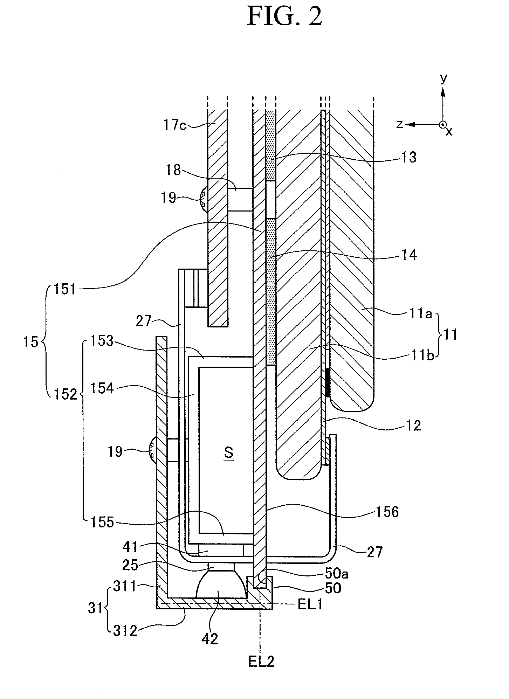

With reference to FIGs. 1 and 2, the plasma display device according to an embodiment of the present invention includes a plasma display panel (PDP) 11, heat dissipation sheets 13, a chassis base 15, and printed circuit board assemblies (PCAs) 17. The PDP 11 includes a front substrate 11a and a rear substrate 11b, and displays an image through gas discharge. The general configuration and function of the PDP 11 is known.

The embodiment of the present invention relates to combining relationships of constituent elements that support the PDP 11 rather than the PDP 11 itself. Thus, a detailed description of the general elements of the PDP 11 will be omitted.

The heat dissipation sheets 13 are provided on a rear surface of the PDP 11 and quickly diffuse heat generated from the interior of the PDP 11 to implement heat balance over the entire plane of the PDP 11. The heat dissipation sheets 13 may be made of, for example, an acrylic heat dissipation material, a graphite heat dissipation material, a metallic heat dissipation material, or a carbon nano-tube-based heat dissipation material, among others.

With reference to FIG. 2, the chassis base 15 is attached to a rear surface of the PDP 11 with double-sided adhesive tape 14, thereby supporting the PDP 11. The chassis base 15 includes a main chassis 151 overlaid on the rear surface of the PDP 11 and a sub-chassis 152 extending from a lower end of the main chassis 151.

More specifically, the sub-chassis 152 includes first and second sidewalls 153, 155 extending from a rear surface of the main chassis 151, and a top wall 154 extending over the first and second sidewalls, the top wall being parallel to the main chassis 151. In other words, the sub-chassis 152 is configured to form a space (S) between the sub-chassis 152 and the PDP 11.

Referring back to FIG. 1, the PCAs 17 are mounted on the rear surface of the chassis base 15 and electrically connected with electrodes of the PDP 11. In FIG. 2, an address electrode 12 is shown and a display electrode is omitted. The PCAs 17 are on bosses 18 provided on the chassis base 15, and are fastened by set screws 19 inserted into the bosses 18.

The PCAs 17 include a sustain electrode driving board 17a that controls a sustain electrode (not shown) among display electrodes, a scan electrode driving board 17b that controls a scan electrode (not shown) among the display electrodes, and an address buffer board 17c that controls the address electrode 12.

The PCAs 17 further include a logic board 17d that receives a video signal from an external source, generates a control signal required for driving the address electrode 12 and a control signal required for driving the sustain electrode and the scan electrode, and applies the controls signals to the corresponding PCAs 17, and a power supply board 17e that supplies power required for driving the PCAs 17.

The sustain electrode driving board 17a is connected to the sustain electrode by a flexible printed circuit (FPC), and the scan electrode driving board 17b is connected to the scan electrode by an FPC. The address buffer board 17c is connected to the address electrode 12 via an FPC 27.

The description for the connection structure of the sustain electrode and the sustain electrode driving board 17a, the connection structure of the scan electrode and the scan electrode driving board 17b, and surroundings of the respective connection structures will be omitted for the sake of convenience. In the present exemplary embodiment, the FPC 27 connecting the address electrode 12 and the address buffer board 17c and its surroundings will be described as follows.

A driver IC 25 that generates a control signal of the address electrode 12 may be mounted on the FPC 27 to, for example, a TCP. A cover plate 31 is fastened to the chassis base 15 by using set screws 19, covering the FPC 27 and the driver IC 25. The cover plate 31 protects the FPC 27 that connects the address electrode 12 and the address buffer board 17c, and the driver IC 25 mounted on the FPC 27.

Accordingly, the FPC 27 and the driver IC 25 are positioned between the chassis base 15 and the cover plate 31. More specifically, the FPC 27 and the driver IC 25 are positioned between the sub-chassis 152 and the cover plate 31.

The cover plate 31 will be described in more detail as follows. For example, the cover plate 31 may include first and second plates 311, 312. The first plate 311 is generally parallel to the chassis base 15, namely, the main chassis 151 and the sub-chassis 152, and the second plate 312 extends generally perpendicularly from the first plate 311.

With reference to FIG. 2, a virtual first extension line EL1 extends from an end of the second plate 312 of the cover plate 31 in a first direction, and a virtual second extension line EL2 extends from an end of the main chassis 51 of the chassis base 15 in a second direction, the first direction being generally perpendicular to the second direction. An intersection of EL1 and EL2 generally defines a center of a receiving recess 50a of a connector 50, as described in more detail below.

The driver IC 25 positioned between the cover plate 31 and the chassis base 15 has a heat dissipating structure to dissipate heat generated during driving. A heat dissipating pad 41 and thermal grease 42 are provided on opposite sides of the driver IC 25 and thermally connect the driver IC 25 to the chassis base 15 and to the cover plate 31, respectively.

In one embodiment, the heat dissipating pad 41 is between the driver IC 25 and the second protrusion 155 of the sub-chassis 152, and the thermal grease 42 is between the driver IC 25 and the second plate 312 of the cover plate 31. Thus, without a shear stress between the second protrusion 155 and the second plate 312, the driver IC 25 does not flex toward the PDP 11 and is less likely to be cracked or damaged.

The plasma display device according to the present exemplary embodiment further includes the connector 50 that connects the cover plate 31 and the chassis base 15 in addition to the set screws 19 for mounting the cover plate 31 to the chassis base 15.

The connector 50 is provided at a position where the virtual first extension line EL1 extending from the cover plate 31 and the virtual second extension line EL2 extending from the chassis base 15 cross each other in order to strengthen the combining support structure of the chassis base 15 and the cover plate 31.

Substantially, the connector 50 connects a free edge of the second plate 312 to a free edge of the main chassis 151 to prevent relative movement between the main chassis 151 and the second cover plate 312. The connector 50 may be integral with either the cover plate 31 or the chassis base 15, and separate from the other thereof (as in the first embodiment), or may be separate from both the cover plate 31 and the chassis base 15 (as in the second and third embodiments).

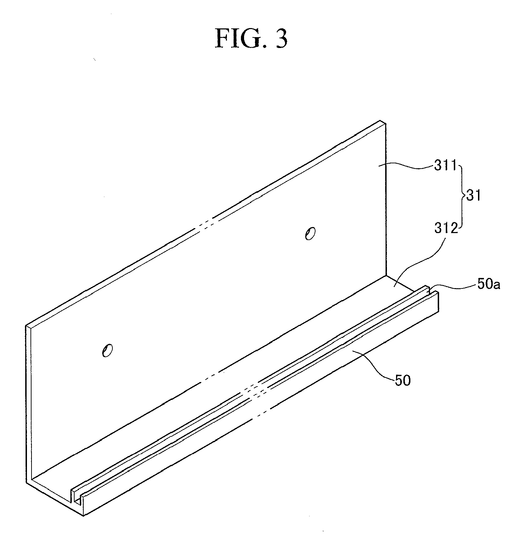

FIG. 3 is a perspective view of the cover plate applied for the first exemplary embodiment. With reference to FIG. 3, the connector 50 is integral with the cover plate 31, and more specifically, is integral with the second plate 312. The connector 50 protrudes from the second plate 312 toward the chassis base 15 and the main chassis 151, and includes the receiving groove 50a on the protruded portion. The receiving groove 50a is adapted to receive and support one end of the chassis base 15 and the main chassis 151.

The receiving groove 50a may be of a length generally corresponding to a length of the chassis base 15, and may extend along an entire length of the second plate 312 as shown in FIG. 2. The receiving groove 50a, the connector 50, and the cover plate 31 may be manufactured by cutting a material by a continuous process such as extrusion or drawing.

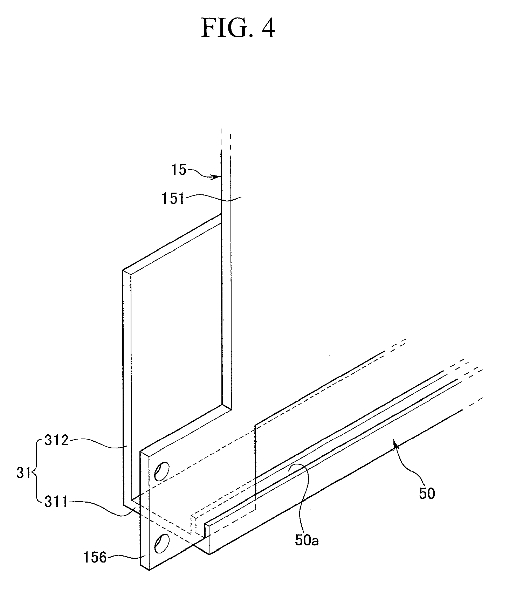

With reference now to FIG. 4, the chassis base 15 includes a tab 156 extending from each corner of the quadrangular main chassis 151. Thus, one side, i.e., the tab 156, of the chassis base 15 and the main chassis 151, is partially inserted into the receiving groove 50a.

The chassis base 15 may include a protrusion between two tabs 156 to be inserted into the receiving recess or groove 50a of the connector 50. In this case, the chassis base 15 and the cover plate 31 may be more securely combined and supported.

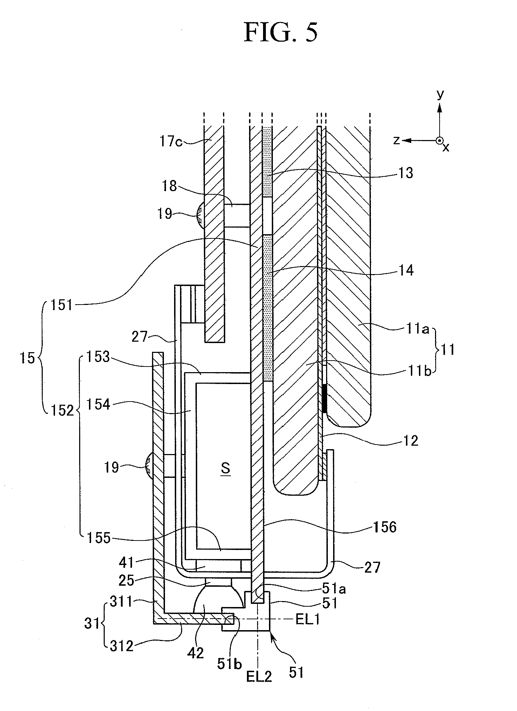

FIG. 5 is a cross-sectional view according to a second exemplary embodiment of the present invention. The second exemplary embodiment of the present invention is similar to the first exemplary embodiment of the present invention in terms of the overall configuration and operational effects, so a description of similar or the same parts will be omitted and different parts will be described.

Compared with the connector 50 according to the first exemplary embodiment of the present invention integral with the cover plate 31, and specifically, the second plate 312, a connector according to the second exemplary embodiment of the present invention is a separate and independent connector 51. Namely, the connector 51 is separate from the second plate 312 and the chassis base 15, and serves to connect adjacent ends of the second plate 312 and the chassis base 15.

The connector 51 includes a first receiving recess 51a and a second receiving recess 51b. The first receiving recess 51a may generally face the main chassis 151 and is adapted to receive and support one end of the main chassis 151. The second receiving recess 51b may generally face the second plate 312 and is adapted to receive and support one end of the second plate 312. In one embodiment, the tab 156 is partially inserted into and supported by the first receiving recess 51a.

Using the connector 51, the cover plate 31 and the second plate 312 can be securely combined with the chassis base 15, and specifically with the tab 156 of the main chassis 151.

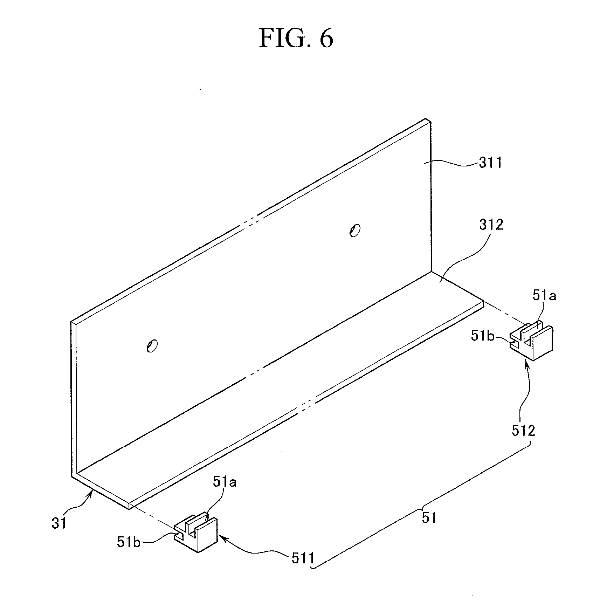

With reference to FIG. 6, the first receiving recess 51a faces a first direction and extends along an entire length of the connector 51 in a lengthwise direction of the chassis base 15. The second receiving recess 51b faces a second direction and extends along an entire length of the connector 51 in a lengthwise direction of the chassis base 15. In one embodiment, the connector 51 includes first and second connectors 511, 512 placed at either end of the chassis base 15. The first connector 511 receives a first edge of the second plate 312 and the corresponding tab 156 and the second connector 512 receives a second edge opposite the first edge of the second plate 312 and the corresponding tab 156. Accordingly, the chassis base 15 and the cover plate 31 can be securely combined and supported.

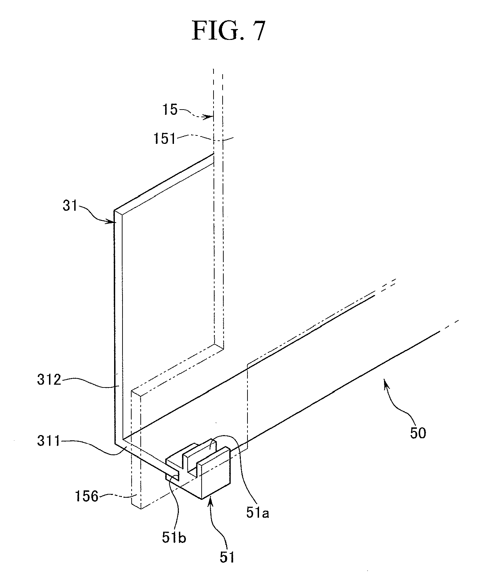

With reference to FIG. 7, the first receiving recess 51a is adapted to receive an edge of the tab 156 of the main chassis 151, and the second receiving recess 51b is adapted to receive an edge of the second plate 312.

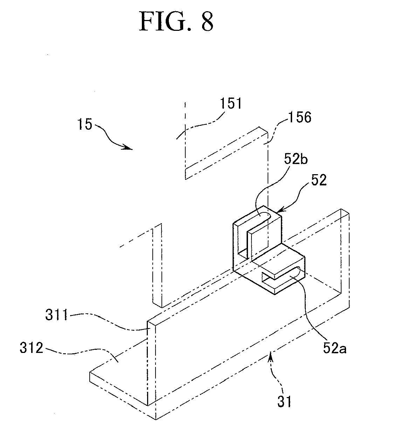

FIG. 8 is a partial perspective view showing a combined structure of a chassis base, a cover plate, and a connector according to a third exemplary embodiment of the present invention. The third exemplary embodiment of the present invention is substantially similar to the second exemplary embodiment in terms of the overall configuration and operational effects, so a description of similar or the same parts will be omitted and different parts will be described.

As shown in FIG. 8, a connector 52 is provided have a first receiving recess 52a and a second receiving recess 52b with an open side and a closed side. In other words, when an edge of the tab 156 or the second plate 312 is inserted into the respective first or second receiving recess 52a, 52b, an edge of the tab or second plate will abut the closed side of the receiving recess.

The first receiving recess 52a is configured such that a portion corresponding to one end of the second plate 312 is closed to cover one end of the second plate 312. The second receiving recess 52b is configured such that a portion corresponding to one end of the chassis base 15 is closed to cover one end of the chassis base 15.

In this manner, in the plasma display device according to the exemplary embodiment of the present invention, because the cover plate 31 and the chassis base 15 are connected by the connector, the support structure of the cover plate 31 with respect to the chassis base 15 is reinforced.

Also, because the cover plate 31 can be prevented from flexing by the reinforced support structure, no significant shear stress is applied to the driver IC 25 positioned between the chassis base 15 and the cover plate 31, and thus the driver IC 25 can be substantially prevented from being cracked or damaged. Therefore, the driver IC 25 can apply normal signals to the address electrodes and deficiencies that may be caused by generation of vertical lines can be prevented. Further, because the support structure is reinforced, noise that may be generated in the vicinity of the cover plate 31 can be reduced.

While the present invention has been described in connection with certain exemplary embodiments, it is to be understood that the invention is not limited to the disclosed embodiments, but, on the contrary, is intended to cover various modifications and equivalent arrangements included within the scope of the appended claims.

## Claims

1. A plasma display device comprising:
a plasma display panel (11);
a chassis base (15) for supporting the plasma display panel;
a printed circuit board assembly (17) on the chassis base;
a flexible printed circuit (27) electrically connecting electrodes of the plasma display panel to the printed circuit board assembly;
a driver integrated circuit (25) on the flexible printed circuit;
a cover plate (31) covering the flexible printed circuit and the driver integrated circuit, the cover plate being mounted on the chassis base; and
a connector (50, 51, 52) for holding an edge of the chassis base to the cover plate to prevent relative movement between the chassis base and the cover plate.

2. The device of claim 1, wherein the cover plate comprises:
a first plate (311) generally parallel to the chassis base; and
a second plate (312) extending from and substantially perpendicular to the first plate.

3. The device of claim 2, wherein the connector (50) is integral with the second plate.

4. The device of claim 3, the connector further comprising at least one receiving recess (50a) adapted to receive and support the edge of the chassis base, wherein the connector protrudes from the second plate toward the chassis base.

5. The device of claim 4, wherein the at least one receiving recess is adapted to receive a corner of the chassis base.

6. The device of claim 4 or 5, wherein a length of the at least one receiving recess corresponds to a length of the second plate.

7. The device of claim 4, 5 or 6, the chassis base comprising a tab (156) at a corner of the chassis base, the tab being at least partially inserted in the at least one receiving recess.

8. The device of claim 2, wherein the connector (51, 52) is separate from the second plate and the chassis base.

9. The device of claim 8, the connector further comprising:
a first receiving recess (51b, 52a) adapted to receive and support an edge of the second plate (312); and
a second receiving recess (51a, 52b) adapted to receive and support the edge of the chassis base.

10. The device of claim 9, the chassis base comprising a tab (156) at a corner of the chassis base, the tab being at least partially inserted in the second receiving recess.

11. The device of claim 9 or 10, wherein the first receiving recess (51b) faces an edge of the second plate and extends along an entire length of the connector, and wherein the second receiving recess (51a) faces the edge of the chassis base and extends along an entire length of the connector.

12. The device of claim 9, wherein the first receiving recess (52a) extends partially along a length of the connector such that the first receiving recess contacts two edges of a corner of the second plate (312), and wherein the second receiving recess (52b) extends partially along a length of the connector such that the second receiving recess contacts two edges of a corner of the chassis base.

13. The device of any one of claims 8 to 12, wherein the connector comprises a first connector and a second connector, the first connector being connected to a first end of the chassis base and the second connector being connected to a second end of the chassis base.

14. The device of any one of the preceding claims, the chassis base comprising a first tab at a first corner of the chassis base and a second tab at a second corner of the chassis base, wherein the connector is adapted to receive the first tab and the second tab.
